# EUROPÄISCHE PATENTSCHRIFT

(11) **EP 4 083 581 B1**
(45) Veröffentlichungstag und Bekanntmachung des Hinweises auf die Patenterteilung: **12.02.2025**
(21) Anmeldenummer: 22170082.6
(22) Anmeldetag: 26.04.2022
(51) Int. Cl.: G01F 1/716, G01F 1/74, G01N 24/08, G01R 33/44

(54) **VERFAHREN ZUM BESTIMMEN EINES FLÜSSIGKEITSANTEILS EINES STRÖMENDEN MEDIUMS MIT EINEM KERNMAGNETISCHEN DURCHFLUSSMESSGERÄT**
METHOD FOR DETERMINING A LIQUID FRACTION OF A FLOWING MEDIUM WITH A NUCLEAR MAGNETIC FLOWMETER
PROCÉDÉ DE DÉTERMINATION D'UNE TENEUR EN LIQUIDE D'UN MILIEU EN ÉCOULEMENT À L'AIDE D'UN DÉBITMÈTRE MAGNÉTIQUE NUCLÉAIRE

(30) Priorität: 30.04.2021 DE 102021111162
(43) Veröffentlichungstag der Anmeldung: 02.11.2022
(73) Patentinhaber: Krohne AG, 4019 Basel (CH)
(72) Erfinder: Tromp, Rutger Reinout, 3311 EM Dordrecht (NL); Cerioni, Lucas Matias Ceferino, 3311 GN Dordrecht (NL)
(74) Vertreter: Gesthuysen Patentanwälte

(56) Entgegenhaltungen:
- EP-A1- 2 910 907
- WO-A1-2015/088888
- WO-A2-98/59220
- GB-A- 2 279 754
- US-A- 5 410 248
- US-A- 5 936 405
- US-A1- 2004 008 027
- M APPEL ET AL: "SPE 141465 Robust Multi-Phase Flow Measurement Using Magnetic Resonance Technology", SPE MIDDLE EAST OIL AND GAS SHOW AND CONFERENCE, 25-28 SEPTEMBER 2011, MANAMA, BAHRAIN, 1 January 2011 (2011-01-01), https://www.onepetro.org/conference-paper/SPE-141465-MS, pages 1 - 20, XP055173490, Retrieved from the Internet <URL:https://www.onepetro.org/download/conference-paper/SPE-141465-MS?id=conference-paper/SPE-141465-MS> [retrieved on 20150303], DOI: http://dx.doi.org/10.2118/141465-MS

## Beschreibung

Die Erfindung betrifft ein Verfahren zum Bestimmen eines Flüssigkeitsanteils eines strömenden Mediums mit einem kernmagnetischen Durchflussmessgerät. Das kernmagnetische Durchflussmessgerät weist ein Messrohr mit einem Messvolumen, eine Messvorrichtung und eine Magnetisierungsvorrichtung auf. Das Medium wird durch das Messrohr geströmt und weist sowohl einen flüssigen Anteil als auch einen gasförmigen Anteil auf. Ein Magnetfeld entlang einer Magnetfeldrichtung wird im Messvolumen von der Magnetisierungsvorrichtung erzeugt und das Medium wird durch das Magnetfeld magnetisiert. Das bedeutet, dass das Medium beim Strömen durch das Messvolumen dem Magnetfeld ausgesetzt ist und durch dieses magnetisiert wird.

Die Erfindung liegt auf dem Gebiet von kernmagnetischen Durchflussmessgeräten. Die Messvorrichtung eines kernmagnetischen Durchflussmessgeräts ist ausgebildet, Messungen an einem durch das Messvolumen des Messrohrs strömenden Medium durchzuführen und aus den Messungen Informationen über das Medium zu bestimmen. Bei der Durchführung einer Messung durch die Messvorrichtung wird eine Präzession von Atomkernen des Mediums bei Anwesenheit des Magnetfelds, welches das Medium zuvor magnetisiert hat, durch Anregung der Atomkerne zu kernmagnetischen Resonanzen beeinflusst und werden die kernmagnetischen Resonanzen gemessen. Eine kernmagnetische Resonanz kann zum Beispiel in Form eines Free Induction Decay (FID) oder eines Spin-Echos auftreten. Solche Messungen werden auch als Magnetresonanzmessungen bezeichnet. Die EP 2 910 907 A1 beschreibt ein entsprechendes kernmagnetisches Durchflussmessgerät gemäß dem Stand der Technik.

Präzession ist eine Eigenschaft von Atomkernen der Elemente, die einen Kernspin aufweisen. Der Kernspin kann als ein durch einen Vektor beschreibbarer Drehimpuls aufgefasst werden und entsprechend kann auch das durch den Kernspin hervorgerufene magnetische Moment durch einen Vektor beschrieben werden, der parallel zum Vektor des Drehimpulses ist. Die Anwesenheit eines makroskopischen Magnetfelds bewirkt einen Überschuss an Atomkernen mit magnetischen Momenten in einem Medium, die parallel zum makroskopischen Magnetfeld ausgerichtet sind, wodurch das Medium eine makroskopische Magnetisierung aufweist, die in ihrer Gesamtheit durch einen Vektor beschrieben werden kann. Der Vektor des magnetischen Moments eines Atomkerns präzessiert bei Anwesenheit eines makroskopischen Magnetfelds um den Vektor des makroskopischen Magnetfelds an der Stelle des Atomkerns. Das ist die Eigenschaft Präzession. Die Frequenz der Präzision wird als Larmorfrequenz f_{L} bezeichnet und ist proportional zum Betrag der magnetischen Flussdichte B des makroskopischen Magnetfelds. Die Larmorfrequenz berechnet sich gemäß f_{L} = (γ/2*π*) B. Darin ist γ das gyromagnetische Verhältnis, welches für Wasserstoffkerne maximal ist. Die Larmorfrequenz wird im Folgenden auch einfach als Frequenz bezeichnet.

Diese magnetischen Momente und Präzessionen werden durch elektromagnetische Pulse beeinflusst, die ein Drehmoment auf die magnetischen Momente ausüben und dadurch die magnetischen Momente um Winkel drehen, die zwischen dem Vektor des magnetischen Moments und dem makroskopischen Magnetfeld abgetragen werden. Wenn im Folgenden von Pulsen die Rede ist, dann sind solche Pulse gemeint.

Da das Medium einen flüssigen und einen gasförmigen Anteil aufweist, weist es auch mindestens zwei Phasen auf. Somit handelt es sich bei dem Medium um ein mehrphasiges Medium. Zum Beispiel ist der gasförmige Anteil eine Phase und ist der flüssige Anteil eine weitere Phase. Oftmals weist der flüssige Anteil auch mehr als eine Phase auf, zum Beispiel die Phasen Rohöl und (Salz-) Wasser. Die gasförmige Phase ist zum Beispiel Erdgas.

Zum Bestimmen von Informationen über die einzelnen Phasen des mehrphasigen Mediums müssen Atomkerne der einzelnen Phasen zu unterscheidbaren kernmagnetischen Resonanzen anregbar sein. Zum Beispiel sind kernmagnetische Resonanzen voneinander unterscheidbar, wenn Spin-Gitter-Relaxationen der einzelnen Phasen voneinander verschiedene Spin-Gitter-Relaxationszeitkonstanten T₁ aufweisen. Die Spin-Gitter-Relaxationszeitkonstante ist eine Eigenschaft einer Phase. Weitere Eigenschaften sind eine Spin-Spin-Relaxationszeitkonstante T₂ und eine Diffusionszeitkonstante D. Unter Verwendung mindestens einer der aufgeführten Eigenschaften können Informationen über Phasen des Mediums bestimmt werden. Informationen sind zum Beispiel Durchflussgeschwindigkeiten einzelner Phasen des Mediums durch das Messrohr und ein Flüssigkeitsanteil des Mediums im Messrohr. Zu den Informationen über die einzelnen Phasen werden auch Eigenschaften der Phasen gezählt.

Die Phasen Rohöl, (Salz-) Wasser und Erdgas sind bereits erwähnt worden. Das sind auch die wesentlichen Phasen eines aus einer Ölquellen geförderten mehrphasigen Mediums. Da die Atomkerne all dieser Phasen Wasserstoffkerne besitzen und für gewöhnlich sich insbesondere die Phasen Rohöl und (Salz-) Wasser durch unterschiedliches Spin-Gitter-Relaxationszeitkonstanten T₁ auszeichnen, sind kernmagnetische Durchflussmessgeräte für das Bestimmen von Informationen von aus Ölquellen geförderten Medien besonders geeignet.

Eine wichtige Information ist der bereits erwähnte Flüssigkeitsanteils des Mediums im Messvolumen des Messrohrs, der im englischen auch als pipe filling factor oder liquid holdup bezeichnet wird. Der Flüssigkeitsanteil ist zum Beispiel der Quotient aus dem vom flüssigen Anteil eingenommenen Volumen im Messvolumen als Dividend und dem Messvolumens als Divisor. Das Messvolumen wird vollständig vom Volumen des flüssigen Anteils und vom Volumen des gasförmigen Anteils eingenommen. Aus dem Stand der Technik ist bekannt, den Flüssigkeitsanteils zu bestimmen, indem zunächst eine kernmagnetische Resonanz im gesamten flüssigen Anteil des Mediums im Messvolumen durch ein Anregungssignal angeregt und dann diese als ein Messsignal gemessen wird. Danach wird eine Amplitude des Messsignals bestimmt und aus der Amplitude der Flüssigkeitsanteil hergeleitet. Diese Art der Bestimmung des Flüssigkeitsanteils hat verschiedene Nachteile.

Ein Nachteil ist, dass auch der gasförmige Anteil durch das Anregungssignal zu einer kernmagnetischen Resonanz angeregt werden und diese dann auch mitgemessen werden kann, sodass sie im Messsignal vorhanden ist und die Amplitude vergrößert und dadurch verfälscht.

Ein weiterer Nachteil ist, dass die kernmagnetische Resonanz nicht unmittelbar nach dem Anregungssignal, sondern erst nach dessen Abklingen gemessen werden kann, da andernfalls das Anregungssignal das Messsignal verfälscht. Bei dem Bestimmen des Flüssigkeitsanteils aus der Amplitude muss die Amplitude zum Zeitpunkt des Anregungssignals bestimmt werden, was eine Extrapolation vom Zeitpunkt der Messung zum Zeitpunkt der Anregung erfordert. Bei dieser Extrapolation sind verschiedene Effekte zu berücksichtigen. So ist zu berücksichtigen, dass das magnetisierte Medium mit der kernmagnetischen Resonanz aus dem Messvolumen mit einer Geschwindigkeit hinausströmt. Weiter ist zu berücksichtigen, dass die kernmagnetische Resonanz aufgrund von Relaxationseffekten, die zum Beispiel durch die Spin-Spin-Relaxationszeitkonstante T₂ beschrieben sind, abnimmt. Die Genauigkeit der Extrapolation hängt somit von der Genauigkeit der Kenntnis der Geschwindigkeit und der Spin-Spin-Relaxationszeitkonstanten ab. Es kommen weitere Effekte hinzu, welche die Genauigkeit der Extrapolation beeinträchtigen.

Ein weiterer Nachteil ist, dass Ungenauigkeiten bei der Kenntnis der Magnetisierung des Mediums im Messvolumen zu einer entsprechenden Ungenauigkeit der Amplitude und damit des Flüssigkeitsanteils führen.

Deshalb ist eine Aufgabe der Erfindung, ein Verfahren anzugeben, welches zumindest einen der aufgeführten Nachteile zumindest abmildert.

Die Aufgabe ist durch ein Verfahren mit den Merkmalen von Patentanspruch 1 gelöst.

Und zwar wird in einem Gradientenschritt von der Magnetisierungsvorrichtung ein Gradientenmagnetfeld mit einem Stärkegradienten entlang einer ersten Gradientenrichtung im Messvolumen erzeugt und wird das Medium dem Gradientenmagnetfeld zusätzlich zum Magnetfeld ausgesetzt. Demnach wird das strömende Medium im Messvolumen gleichzeitig sowohl dem Magnetfeld als auch dem Gradientenmagnetfeld ausgesetzt.

Weiter werden die folgenden Messschritte von der Messvorrichtung ausgeführt:
- Erzeugen und Einstrahlen eines Anregungssignals in das magnetisierte Medium im Messvolumen zum Anregen von kernmagnetischen Resonanzen im magnetisierten Medium entlang der ersten Gradientenrichtung. Durch das Gradientenmagnetfeld unterscheiden sich die angeregten kernmagnetischen Resonanzen entlang der ersten Gradientenrichtung voneinander.
- Messen von vom Anregungssignal angeregten kernmagnetischen Resonanzen im magnetisierten Medium entlang der ersten Gradientenrichtung im Messvolumen als ein Messsignal. Somit werden kernmagnetische Resonanzen im Medium gemessen, die von dem Anregungssignal zuvor angeregt worden sind.
- Bestimmen von Frequenzen der kernmagnetischen Resonanzen im Messsignal entlang der ersten Gradientenrichtung. Das Bestimmen der Frequenzen umfasst z. B. Fourier-Transformationen. Durch die Überlagerung des Magnetfelds, mit dem Gradientenmagnetfeld sind die Frequenzen gemäß f_{L} = (γ/2*π*) B abhängig von einer Position des Mediums entlang der ersten Gradientenrichtung. B ist die magnetische Flussdichte, die sich durch die Überlagerung des Magnetfelds und des Gradientenmagnetfelds ergibt. Eine infinitesimal dünne Scheibe des Mediums im Messvolumen, die orthogonal zur ersten Gradientenrichtung ausgerichtet ist, weist eine Frequenz auf. Nimmt z. B. eine Stärke des Gradientenmagnetfelds in der ersten Gradientenrichtung zu, dann nehmen auch die Frequenzen in der ersten Gradientenrichtung in den Scheiben des Mediums gemäß dem gyromagnetischen Verhältnis zu.

Die Messschritte werden ausgeführt, während sich das strömende Medium im Wesentlichen im Messvolumen befindet.

Dann werden die folgenden Auswertungsschritte von der Messvorrichtung ausgeführt:
- Zuordnen der bestimmten Frequenzen zu Positionen entlang der ersten Gradientenrichtung. Den Positionen werden z. B. dünne Scheiben des Mediums im Messvolumen, die orthogonal zur ersten Gradientenrichtung angeordnet sind, zugeordnet, wobei die Scheiben derart dünn sind, dass ihnen jeweils eine Frequenz zugeordnet wird.
- Zuordnen der kernmagnetischen Resonanzen an den Positionen zum flüssigen Anteil und zum gasförmigen Anteil des Mediums. Da die einzelnen Phase des Medium und damit auch der flüssige und der gasförmige Anteil des Mediums zu unterscheidbaren kernmagnetischen Resonanzen angeregt werden, können die kernmagnetischen Resonanzen an den Positionen auch entweder dem flüssigen oder dem gasförmigen Anteil des Mediums zugeordnet werden. Die Zuordnung der kernmagnetischen Resonanzen zum flüssigen und gasförmigen Anteil erfolgt vorzugsweise durch Auswertung einer Stärke der kernmagnetischen Resonanzen, wie z. B. Amplituden. Eine Stärke einer kernmagnetischen Resonanz des flüssigen Anteils ist größer als eine Stärke einer kernmagnetischen Resonanz des gasförmigen Anteils.
- Bestimmen eines Flüssigkeitsanteils des strömenden Mediums im Messvolumen aus den Positionen der kernmagnetischen Resonanzen des flüssigen Anteils und den Positionen der kernmagnetischen Resonanzen des gasförmigen Anteils. Beim Bestimmen wird auch das Messvolumen, insbesondere seine Geometrie berücksichtigt.

Das erfindungsgemäße Verfahren zum Bestimmen des Flüssigkeitsanteils mildert die zuvor aufgezeigten Nachteile zumindest ab. Ein unbeabsichtigtes Anregen von kernmagnetischen Resonanzen im gasförmigen Anteil erfolgt nicht. Der Umstand dass eine kernmagnetische Resonanz nicht unmittelbar nach dem Anregungssignal, sondern erst nach dem anklingen gemessen werden kann, hat keine negativen Auswirkungen. Auch führen Ungenauigkeiten bei der Kenntnis der Magnetisierung des Mediums nicht zu Verfälschungen des Flüssigkeitsanteils.

In einer ersten Ausgestaltung des Verfahrens werden das Messrohr horizontal und die erste Gradientenrichtung vertikal orientiert. Die Angaben horizontal und vertikal beziehen sich auf den Schwerefeldvektor. Eine horizontale Orientierung ist senkrecht zum Schwerefeldvektor und eine vertikale Orientierung ist parallel zu diesem. Die horizontale Ausrichtung des Messrohrs bewirkt eine horizontale Schichtung des flüssigen und des gasförmigen Anteils im Messrohr durch die Schwerkraft. Durch die vertikale Orientierung der ersten Gradientenrichtung gehen durch die Positionen entlang der ersten Gradientenrichtung Ebenen senkrecht zur ersten Gradientenrichtung, welche ebenfalls horizontal sind. Dadurch, dass der flüssige und der gasförmigen Anteil des Mediums horizontal geschichtet sind und die Ebenen ebenfalls horizontal ausgerichtet sind, erfolgt ein präziseres Bestimmen eines Übergangs zwischen dem flüssigen und dem gasförmigen Anteil.

Das Magnetfeld weist eine bestimmte Homogenität auf und ist in diesem Sinne homogen. Das bedeutet, das Magnetfeld weist geringe Schwankungen auf. Zum Beispiel weist das Magnetfeld eine magnetische Flussdichte von 0,2 T auf und betragen die Schwankungen 1000 ppm. Daraus ergibt sich eine Frequenzunsicherheit von Δf_{L} = (γ/2*π*) ΔB = 42,58 MHz/T · 0,2 T · 1000 ppm = 8,5 kHz. Das Gradientenmagnetfeld hat zum Beispiel einen Stärkegradienten von G = 0,25 mT/cm. Die Frequenzunsicherheit korrespondiert dann mit einer Ortsunsicherheit von Δd = ΔB / G = 0,8 cm. Wenn das Messrohr einen Innendurchmesser von zum Beispiel 10 cm hat und die erste Gradientenrichtung mit diesem zusammenfällt, dann korrespondiert die Ortsunsicherheit von 0,8 cm mit einer Präzision von 0,8 cm / 10 cm = 8 %.

Um eine geforderte Präzision umzusetzen, ist in einer weiteren Ausgestaltung des Verfahrens vorgesehen, dass eine Homogenität des Magnetfelds bestimmt wird und dass eine Stärke für den Stärkegradienten basierend auf der bestimmten Homogenität und einer geforderten Präzision entlang der Gradientenrichtung bestimmt wird. Bevorzugt liegt die geforderte Präzision innerhalb von 10 %, bevorzugter innerhalb von 5 % und besonders bevorzugt innerhalb von 1 % einer Strecke entlang der Gradientenrichtung im Messvolumen. Bevorzugt wird die Homogenität des Magnetfelds von der Magnetisierungsvorrichtung bestimmt. Die Strecke entlang der Gradientenrichtung ist zum Beispiel ein Durchmesser des Messrohrs.

Erfindungsgemäß weist das Anregungssignal mindestens einen Anregungspuls auf. Ein Anregungspuls, der in das magnetisierte Medium im Messvolumen eingestrahlt wird, regt kernmagnetische Resonanzen in dem magnetisierten Medium entlang der ersten Gradientenrichtung an. Dazu muss der Anregungspuls eine bestimmte Bandbreite aufweisen. Die Bandbreite wird derart bestimmt, dass ein Anregungspuls das Medium entlang der ersten Gradientenrichtung im Messvolumen vollständig zu kernmagnetischen Resonanzen anregt. Weiter ist erfindungsgemäß vorgesehen, dass von der Magnetisierungsvorrichtung eine Bandbreite für den mindestens einen Anregungspuls basierend auf einer Homogenität des Magnetfelds und einer Stärke des Stärkegradienten bestimmt wird. Bevorzugt wird der mindestens eine Anregungspuls zum Rotieren von magnetischen Momenten des magnetisieren Mediums um Winkel zwischen 5° und 45° und bevorzugter um Winkel von 90° erzeugt. Bevorzugt wird ein Hard-, Soft-, ein adiabatischer, ein CHIRP- oder ein WURST-Puls als der mindestens eine Anregungspuls verwendet.

Ein Anregungspuls regt kernmagnetische Resonanzen, die voneinander verschiedenen Frequenzen aufweisen, für gewöhnlich nicht mit gleicher Effizienz an. Demnach ist die Effizienz der Anregung von kernmagnetischen Resonanzen frequenzabhängig. Dadurch haben kernmagnetische Resonanzen unterschiedlicher Frequenzen auch unterschiedliche Stärken, was ein Nachteil bei den Auswertungsschritten darstellt. Deshalb ist in einer Weiterbildung der vorstehenden Ausgestaltung vorgesehen, dass von der Magnetisierungsvorrichtung eine Stärke der kernmagnetischen Resonanzen in Bezug auf ihre Frequenzen bestimmt wird und dass die Stärke der kernmagnetischen Resonanzen in Bezug auf ihre Frequenzen normalisiert wird, sodass eine frequenzabhängige Effizienz der Anregung der kernmagnetischen Resonanzen durch den mindestens einen Anregungspuls kompensiert ist.

In einer weiteren Ausgestaltung ist vorgesehen, dass das Anregungssignal mindestens einen Refokussierungspuls aufweist. Ein Refokussierungspuls, der in das magnetisierte Medium im Messvolumen angestrahlt wird, refokussiert eine zuvor angeregte kernmagnetische Resonanz wieder. Bevorzugt wird der mindestens eine Refokussierungspuls zum Rotieren von magnetischen Momenten des magnetisieren Mediums um Winkel von 45° und bevorzugter um Winkel von 180° erzeugt. Bevorzugt wird ein Hard-, ein Soft-, ein adiabatischer, ein CHIRP- oder ein WURST-Puls als der mindestens eine Refokussierungspuls verwendet.

In einer weiteren Ausgestaltung weist das Anregungssignal eine Multi-Echo-Pulsfolge auf und werden von der Multi-Echo-Pulsfolge im magnetisierten Medium angeregte kernmagnetische Resonanzen gemessen und ausgewertet. Eine Multi-Echo-Pulsfolge weist mindestens einen Anregungspuls und mindestens einen Refokussierungspuls, vorzugsweise mindestens zwei Refokussierungspulse auf. Das Messsignal weist die von der Multi-Echo-Pulsfolge im magnetisierten Medium angeregten kernmagnetischen Resonanzen auf. Durch die Verwendung der Multi-Echo-Pulsfolge weist das Messsignal mehr Informationen auf, als für das Bestimmen des Flüssigkeitsanteils benötigt werden. Bevorzugt werden die von der Multi-Echo-Pulsfolge im magnetisierten Medium angeregten kernmagnetischen Resonanzen durch Bestimmen von mindestens einer Durchflussgeschwindigkeit des magnetisierten Mediums ausgewertet. Es werden also weitere Auswertungsschritte ausgeführt. Somit ergibt die Auswertung zum einen den Flüssigkeitsanteil und zum anderen in diesem Beispiel eine Durchflussgeschwindigkeit. Bevorzugt wird eine CPMG-, eine SSFP- oder eine MMME-Pulsfolge als die Multi-Echo-Pulsfolge verwendet. CPMG steht dabei für Carr-Purcell-Meiboom-Gill, SSFP für Steady-State-Free-Precession und MMME für Multiple-Modulation-Multiple-Echoes.

In einer weiteren Ausgestaltung weist das Anregungssignal einen Anregungspuls gefolgt von einem Refokussierungspuls auf und wird ein vom Refokussierungspuls angeregtes Spin-Echo gemessen. Bevorzugt wird der Refokussierungspuls zum Rotieren von magnetischen Momenten im magnetisierten Medium um Winkel von 180° erzeugt.

In einer Weiterbildung weist das Anregungssignal eine CPMG-Pulsfolge auf und sind der Anregungspuls und der Refokussierungspuls ein Teil der CPMG-Pulsfolge. Während der Anregungspuls und der Refokussierungspuls die Informationen im Messsignal bewirken, welche das Bestimmen des Flüssigkeitsanteils ermöglichen, bewirken die darüber hinausgehenden Bestandteile der CPMG-Pulsfolge weitere Informationen im Messsignal, die ausgewertet werden können. Entsprechend ist in der Weiterbildung auch vorgesehen, dass von der CPMG-Pulsfolge angeregte kernmagnetische Resonanzen gemessen und ausgewertet werden. Insbesondere werden die kernmagnetischen Resonanzen durch das Bestimmen von mindestens einer Durchflussgeschwindigkeit des magnetisierten Mediums ausgewertet. Es werden also weitere Auswertungsschritte von der Messvorrichtung ausgeführt.

In einer weiteren Ausgestaltung weist das Anregungssignal einen ersten Anregungspuls gefolgt von einem ersten Refokussierungspuls und einem zweiten Refokussierungspuls gefolgt von einem zweiten Anregungspuls auf. Der zweite Anregungspuls dient zum Kompensieren von noch vorhandenen kernmagnetischen Resonanzen. Weiter wird ein Spin-Echo zwischen dem ersten Refokussierungspuls und dem zweiten Refokussierungspuls als Messsignal oder als ein Teil des Messsignals gemessen. Bevorzugt weist der zweite Anregungspuls eine Phasenverschiebung von 180° gegenüber dem ersten Anregungspuls auf. Dieser Teil des Messsignals weist die Information zum Betimmen des Flüssigkeitsanteils auf.

In einer Weiterbildung der vorstehenden Ausgestaltung weist das Anregungssignal eine CPMG-Pulsfolge auf und die CPMG-Pulsfolge folgt auf den zweiten Anregungspuls. Zwischen dem zweiten Anregungspuls und der CPMG-Pulsfolge wird das Gradientenmagnetfeld reduziert, bevorzugt auf Null reduziert. Weiter werden von der CPMG-Pulsfolge angeregte kernmagnetische Resonanzen gemessen und ausgewertet, insbesondere ausgewertet durch Bestimmen von mindestens einer Durchflussgeschwindigkeit des magnetisierten Mediums. Die von der CPMG-Pulsfolge angeregten kernmagnetischen Resonanzen sind ein weiterer Teil des Messsignals und es werden also weitere Auswertungsschritte von der Messvorrichtung ausgeführt.

In einer alternativen Weiterbildung der vorstehenden Ausgestaltung weist das Anregungssignal eine MMME-Pulsfolge auf und folgt die MMME-Pulsfolge auf den zweiten Anregungspuls. Zwischen dem zweiten Anregungspuls und der MMME-Pulsfolge wird das Gradientenmagnetfeld zunächst auf Null reduziert und dann wieder erhöht in einer zweiten Gradientenrichtung. Bevorzugt ist die zweite Gradientenrichtung senkrecht zur ersten Gradientenrichtung orientiert, insbesondere parallel zu einer Strömungsrichtung des Mediums. Weiter werden von der MMME-Pulsfolge angeregte kernmagnetische Resonanzen gemessen und ausgewertet, insbesondere ausgewertet durch Bestimmen von mindestens einer Durchflussgeschwindigkeit des magnetisierten Mediums. Die von der CPMG-Pulsfolge angeregten kernmagnetischen Resonanzen sind ein weiterer Teil des Messsignals und es werden also weitere Auswertungsschritte von der Messvorrichtung ausgeführt.

In einer weiteren Ausgestaltung des Verfahrens wird der Gradientenschritt erneut mit einer von der ersten Gradientenrichtung verschiedenen dritten Gradientenrichtung ausgeführt. Dann werden die Messschritte und die Auswertungsschritte erneut ausgeführt. Weiter wird eine Präzision der Bestimmung des Flüssigkeitsanteils durch Kombination von den beiden Bestimmungen des Flüssigkeitsanteils verbessert. Bevorzugt ist die dritte Gradientenrichtung senkrecht zur ersten Gradientenrichtung.

Im Einzelnen ist eine Vielzahl von Möglichkeiten gegeben, das Verfahren auszugestalten und weiterzubilden. Dazu wird verwiesen sowohl auf die Patentanspruch 1 nachgeordneten Patentansprüche als auch auf die nachfolgende Beschreibung bevorzugter Ausführungsbeispiele in Verbindung mit der Zeichnung. In der Zeichnung zeigt
- Fig. 1: ein Ausführungsbeispiel eines kernmagnetischen Durchflussmessgeräts zum Durchführen eines Ausführungsbeispiels eines Verfahrens zum Bestimmen eines Flüssigkeitsanteils,
- Fig. 2: ein erstes Ausführungsbeispiel einer Signalfolge des Verfahrens,
- Fig. 3: ein zweites Ausführungsbeispiel einer Signalfolge des Verfahrens,
- Fig. 4: ein drittes Ausführungsbeispiel einer Signalfolge des Verfahrens und
- Fig. 5: ein viertes Ausführungsbeispiel einer Signalfolge des Verfahrens.

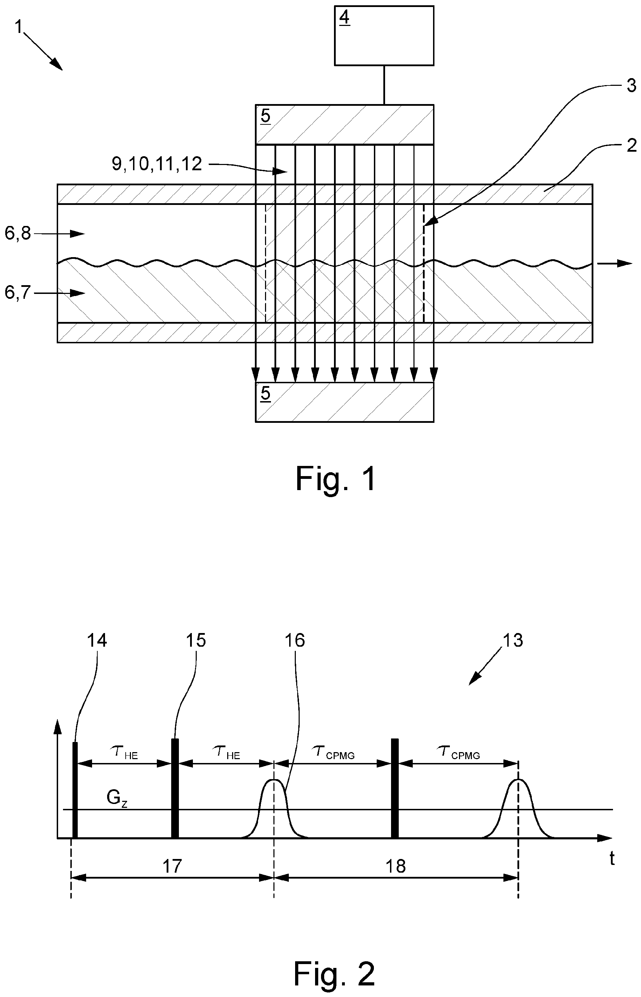

Fig. 1 zeigt ein Ausführungsbeispiel eines kernmagnetischen Durchflussmessgeräts 1, welches ausgebildet ist, das im Folgenden beschriebene Ausführungsbeispiel eines Verfahren zum Bestimmen eines Flüssigkeitsanteils eines strömenden Mediums auszuführen. Die Darstellung des kernmagnetischen Durchflussmessgeräts 1 ist teilweise geschnitten.

Das kernmagnetische Durchflussmessgerät 1 weist ein Messrohr 2 mit einem Messvolumen 3, eine Messvorrichtung 4 und eine Magnetisierungsvorrichtung 5 auf. Das Messrohr 2 ist horizontal orientiert.

Das kernmagnetische Durchflussmessgerät 1 ist im Betrieb, weshalb ein Medium 6 durch das Messrohr 2 geströmt wird. Das Strömen und dessen Richtung ist durch einen Pfeil angedeutet. Das Medium 6 weist einen flüssigen Anteil 7 und einen gasförmigen Anteil 8 auf. Der flüssige Anteil 7 ist eine Phase und der gasförmige Anteil 8 ist eine weitere Phase. Die horizontale Orientierung des Messrohrs 2 bewirkt eine horizontale Schichtung des flüssigen Anteils 7 und des gasförmigen Anteils 8 im Messrohr 2 durch die Schwerkraft. Weiter wird vom kernmagnetischen Durchflussmessgerät 1 das im Folgenden beschriebene Verfahren ausgeführt wird.

Von der Magnetisierungsvorrichtung 5 wird zum einen ein Magnetfeld 9 entlang einer Magnetfeldrichtung 10 im Messvolumen 3 und zum anderen ein Gradientenmagnetfeld 11 mit einem Stärkegradienten entlang einer ersten Gradientenrichtung 12 im Messvolumen erzeugt. Die Magnetfeldrichtung 10 und die Gradientenfeldrichtung 12 sind parallel zueinander und senkrecht orientiert. In Fig. 1 ist eine Überlagerung vom Magnetfeld 9 und vom Gradientenmagnetfeld 11 eingezeichnet. Das Medium 6 wird im Messvolumen 3 sowohl dem Magnetfeld 9 als auch auch dem Gradientenfeld 11 ausgesetzt, wobei es durch das Magnetfeld 9 magnetisiert wird, sodass kernmagnetische Messungen an dem magnetisierten Medium 6 vorgenommen werden können.

Die im Folgenden beschriebenen Ausführungsbeispiele des Verfahrens bauen jeweils auf den vorstehend beschriebenen von der Magnetisierungsvorrichtung 5 ausgeführten Schritten auf.

In einem Ausführungsbeispiel, siehe Fig. 2, führt die Messvorrichtung 4 die folgenden Schritte aus:
- Erzeugen und Einstrahlen eines Anregungssignals in das magnetisierte Medium 6 im Messvolumen 3 zum Anregen von kernmagnetischen Resonanzen im magnetisierten Medium 6 entlang der ersten Gradientenrichtung 12. Das Anregungssignal weist eine CPMG-Pulsfolge 13 mit einem Anregungspuls 14 und einem Refokussierungspuls 15 auf. Der Refokussierungspuls 15 folgt auf den Anregungspuls 14. Der Refokussierungspuls 15 wird zum Rotieren von magnetischen Momenten im magnetisierten Medium 6 um Winkel von 180° erzeugt.
- Messen von vom Anregungssignal, also der CPMG-Pulsfolge 13, angeregten kernmagnetischen Resonanzen im magnetisierten Medium 6 entlang der ersten Gradientenrichtung 12 im Messvolumen 3 als ein Messsignal. Insbesondere wird ein vom Refokussierungspuls angeregtes Spin-Echo 16 gemessen.

- Bestimmen von Frequenzen des Spin-Echos 16 entlang der ersten Gradientenrichtung 12.
- Zuordnen der bestimmten Frequenzen zu Positionen entlang der ersten Gradientenrichtung 12.
- Zuordnen des Spin-Echos 16 an den Positionen zum flüssigen Anteil 7 und zum gasförmigen Anteil 8 des Mediums 6.
- Bestimmen eines Flüssigkeitsanteils des strömenden Mediums 6 im Messvolumen 3 aus den Positionen des Spin-Echos 16 des flüssigen Anteils 7 und den Positionen Spin-Echos 16 des gasförmigen Anteils 8 des Mediums 6. Im vorliegenden Fall strömt das Medium 6 laminar und beträgt der Flüssigkeitsanteil 50 %, siehe Fig. 1.
- Bestimmen von einer Durchflussgeschwindigkeit des magnetisierten Mediums 6 aus den gemessenen kernmagnetischen Resonanzen.

In einem ersten Abschnitt 17 erfolgt das Bestimmen des Flüssigkeitsanteils und in einem zweiten Abschnitt 18 erfolgt das Bestimmen der Durchflussgeschwindigkeit. Abstände zwischen den einzelnen Signalen sind mit τ_{HE} und τ_{CPMG} gekennzeichnet. Eine Stärke des Gradientenmagnetfelds ist als G_{z} eingezeichnet. Signale sind insbesondere beliebige Anregungspulse, Refokussierungspulse, FIDs und Spin-Echos.

Anstelle des Spin-Echos 16 kann auch ein späteres Spin-Echo zum Bestimmen des Flüssigkeitsanteils verwendet werden, welches durch einen späteren Refokussierungspuls angeregt wird. Auch ist die Verwendung eines FID möglich. Jedoch ist das Bestimmen des Flüssigkeitsanteils mit einem FID ungenauer als mit einem Spin-Echo.

Ein Nachteil dieses Ausführungsbeispiels ist, dass der Refokussierungspuls 15 oftmals eine geringere Bandbreite hat als der Anregungspuls 14, wodurch eine Qualität des Messsignals abnimmt.

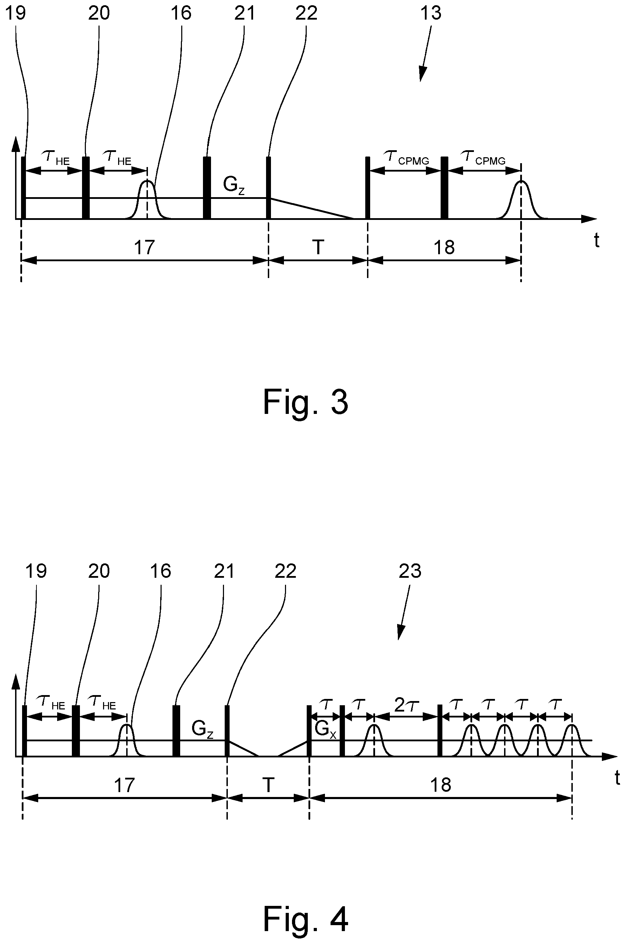

Dieser Nachteil ist in einem weiteren Ausführungsbeispiel, siehe Fig. 3, jedenfalls abgemildert. Die Messvorrichtung 4 führt in diesem Ausführungsbeispiel die folgenden Schritte aus:
- Erzeugen und Einstrahlen eines Anregungssignals in das magnetisierte Medium 6 im Messvolumen 3 zum Anregen von kernmagnetischen Resonanzen im magnetisierten Medium 6 entlang der ersten Gradientenrichtung 12. Das Anregungssignal weist einen ersten Anregungspuls 19 gefolgt von einem ersten Refokussierungspuls 20 und einem zweiten Refokussierungspuls 21 gefolgt von einem zweiten Anregungspuls 22 zum Kompensieren von noch vorhandenen kernmagnetischen Resonanzen auf. Der zweite Anregungspuls 22 weist eine Phasenverschiebung von 180° gegenüber dem ersten Anregungspuls 19 auf. Weiter weist das Anregungssignal eine CPMG-Pulsfolge 13 auf, die auf den zweiten Anregungspuls 22 folgt und verschieden von der aus dem vorangehenden Ausführungsbeispiel sein kann. Zwischen dem zweiten Anregungspuls 22 und der CPMG-Pulsfolge 13 wird das Gradientenmagnetfeld 11 auf Null reduziert. Die Stärke des Gradientenmagnetfelds 11 ist als G_{z} eingezeichnet und die Reduktion auf Null erfolgt innerhalb einer Zeitdauer T.

- Messen von vom Anregungssignal angeregten kernmagnetischen Resonanzen im magnetisierten Medium 6 entlang der ersten Gradientenrichtung 12 im Messvolumen 3 als ein Messsignal. Insbesondere wird ein Spin-Echo 16 zwischen dem ersten Refokussierungspuls 20 und dem zweiten Refokussierungspuls 21 als ein Teil des Messsignals gemessen.
- Bestimmen von Frequenzen des Spin-Echos 16 entlang der ersten Gradientenrichtung 12.
- Zuordnen der bestimmten Frequenzen zu Positionen entlang der ersten Gradientenrichtung 12.
- Zuordnen des Spin-Echos 16 an den Positionen zum flüssigen Anteil 7 und zum gasförmigen Anteil 8 des Mediums 6.
- Bestimmen eines Flüssigkeitsanteils des strömenden Mediums 6 im Messvolumen 3 aus den Positionen des Spin-Echos 16 des flüssigen Anteils 7 und den Positionen des Spin-Echos 16 des gasförmigen Anteils 8 des Mediums 6.
- Bestimmen von einer Durchflussgeschwindigkeit des magnetisierten Mediums 6 aus von der CPMG-Pulsfolge 13 angeregten kernmagnetischen Resonanzen, die ein Teil des Messsignals sind.

Im ersten Abschnitt 17 erfolgt das Bestimmen des Flüssigkeitsanteils und im zweiten Abschnitt 18 erfolgt das Bestimmen der Durchflussgeschwindigkeit, wobei die beiden Abschnitte durch die Zeitdauer T voneinander getrennt sind. Abstände zwischen den einzelnen Signalen sind mit τ_{HE} und τ_{CPMG} gekennzeichnet.

Anstelle des Spin-Echos 16 kann auch hier ein späteres Spin-Echo zum Bestimmen des Flüssigkeitsanteils verwendet werden, welches durch einen späteren Refokussierungspuls angeregt wird. Auch ist die Verwendung eines FID möglich.

Ein Nachteil dieses Ausführungsbeispiels ist, dass zur Bestimmung der Durchflussgeschwindigkeit mit einer CPMG-Pulsfolge viele Spin-Echos benötigt werden, wodurch die zeitliche Auflösung gering ist und Änderungen der zu messenden Durchflussgeschwindigkeit während der Messung zu Fehlern führen.

Dieser Nachteil ist in einem weiteren Ausführungsbeispiel, siehe Fig. 4, jedenfalls abgemildert. Die Messvorrichtung 4 führt in diesem Ausführungsbeispiel die folgenden Schritte aus:
- Erzeugen und Einstrahlen eines Anregungssignals in das magnetisierte Medium 6 im Messvolumen 3 zum Anregen von kernmagnetischen Resonanzen im magnetisierten Medium 6 entlang der ersten Gradientenrichtung 12. Das Anregungssignal weist einen ersten Anregungspuls 19 gefolgt von einem ersten Refokussierungspuls 20 und einem zweiten Refokussierungspuls 21 gefolgt von einem zweiten Anregungspuls 22 zum Kompensieren von noch vorhandenen kernmagnetischen Resonanzen auf. Der zweite Anregungspuls 22 weist eine Phasenverschiebung von 180° gegenüber dem ersten Anregungspuls auf. Weiter weist das Anregungssignal eine MMME-Pulsfolge 23 auf, die auf den zweiten Anregungspuls 22 folgt. Zwischen dem zweiten Anregungspuls 22 und der MMME-Pulsfolge 23 wird das Gradientenmagnetfeld 11 auf Null reduziert und dann in einer zweiten Gradientenrichtung wieder erhöht. Die zweite Gradientenrichtung ist senkrecht zur ersten Gradientenrichtung 12, und zwar parallel zur Strömung des Mediums 6. Die Stärke des Gradientenmagnetfelds 11 in der ersten Gradientenrichtung 12 ist als G_{z} und in der zweiten Gradientenrichtung als Gₓ eingezeichnet. Die Reduktion auf Null und der Anstieg erfolgen innerhalb einer Zeitdauer T.
- Messen von vom Anregungssignal angeregten kernmagnetischen Resonanzen im magnetisierten Medium 6 entlang der ersten Gradientenrichtung 12 im Messvolumen 3 als ein Messsignal. Insbesondere wird ein Spin-Echo 16 zwischen dem ersten Refokussierungspuls 20 und dem zweiten Refokussierungspuls 21 als ein Teil des Messsignals gemessen.

- Bestimmen von Frequenzen des Spin-Echos 16 entlang der ersten Gradientenrichtung 12.
- Zuordnen der bestimmten Frequenzen zu Positionen entlang der ersten Gradientenrichtung 12.
- Zuordnen des Spin-Echos 16 an den Positionen zum flüssigen Anteil 7 und zum gasförmigen Anteil 8 des Mediums 6.
- Bestimmen eines Flüssigkeitsanteils des strömenden Mediums 6 im Messvolumen 3 aus den Positionen des Spin-Echos 16 des flüssigen Anteils 7 und den Positionen des Spin-Echos 16 des gasförmigen Anteils 8 des Mediums 6.
- Bestimmen von einer Durchflussgeschwindigkeit des magnetisierten Mediums 6 aus von der MMME-Pulsfolge angeregten kernmagnetischen Resonanzen, die ein Teil des Messsignals sind. Der Zeitbedarf für das Bestimmen der Durchflussgeschwindigkeit mit der MMME-Pulsfolge 23 ist wesentlich geringer als mit einer CPMG-Pulsfolge.

Im ersten Abschnitt 17 erfolgt das Bestimmen des Flüssigkeitsanteils und im zweiten Abschnitt 18 erfolgt das Bestimmen der Durchflussgeschwindigkeit, wobei die beiden Abschnitte durch die Zeitdauer T voneinander getrennt sind. Abstände zwischen den einzelnen Signalen sind mit τ_{HE} und τ gekennzeichnet.

Anstelle des Spin-Echos 16 kann auch hier ein späteres Spin-Echo zum Bestimmen des Flüssigkeitsanteils verwendet werden, welches durch einen späteren Refokussierungspuls angeregt wird. Auch ist die Verwendung eines FID möglich.

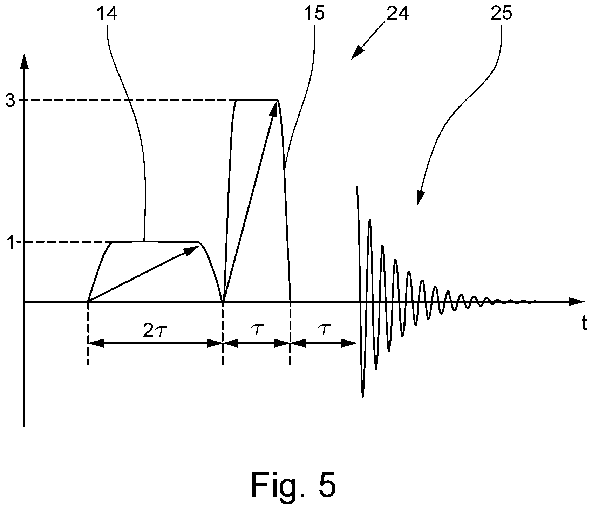

In einem weiteren Ausführungsbeispiel, siehe Fig. 5, führt die Messvorrichtung 4 die folgenden Schritte aus:
- Erzeugen und Einstrahlen eines Anregungssignals in das magnetisierte Medium 6 im Messvolumen 3 zum Anregen von kernmagnetischen Resonanzen im magnetisierten Medium 6 entlang der ersten Gradientenrichtung 12. Das Anregungssignal weist eine CHIRP-Pulsfolge 24 mit einem Anregungspuls 14 gefolgt von einem Refokussierungspuls 15 auf. In Fig. 5 sind nur die Einhüllenden des Anregungspulses 14 und des Refokussierungspulses 15 dargestellt. Die Einhüllenden haben die für Hard-Pulse übliche im Wesentlichen rechteckige Form. Eine Frequenz des Anregungspulses 14 und eine Frequenz des Refokussierungspulses 15 nimmt während ihrer jeweiligen Dauer zu, vorliegend linear zu. Während der Anregungspuls 14 eine Dauer von 2τ und eine normalisierte Amplitude von 1 aufweist, weist der Refokussierungspuls 15 eine Dauer von τ und eine normalisierte Amplitude von 3 auf.
- Messen von einem vom Anregungssignal, also der CHIRP-Pulsfolge, angeregten FID 25 im magnetisierten Medium 6 entlang der ersten Gradientenrichtung 12 im Messvolumen 3 als ein Messsignal. Dabei erfolgt das Messen eine Dauer τ nach dem Refokussierungspuls 15, um Probleme mit Totzeiten zu vermeiden.
- Bestimmen von Frequenzen des FID 25 entlang der ersten Gradientenrichtung 12.
- Zuordnen der bestimmten Frequenzen zu Positionen entlang der ersten Gradientenrichtung 12.
- Zuordnen des FID 25 an den Positionen zum flüssigen Anteil 7 und zum gasförmigen Anteil 8 des Mediums 6.
- Bestimmen eines Flüssigkeitsanteils des strömenden Mediums 6 im Messvolumen 3 aus den Positionen des FID 25 des flüssigen Anteils 7 und den Positionen FID 25 des gasförmigen Anteils 8 des Mediums 6.

Die Fig. 2 bis 5 zeigen schematische Auszüge von Signalfolgen. Das bedeutet insbesondere, dass neben den dargestellten auch noch weitere Signale in den Signalfolgen enthalten sein können. Eine explizite Zuordnung der beschriebenen Schritte zu den Mess- und Auswertungsschritten ist nicht erfolgt, lässt sich aber der den Ausführungsbeispielen vorangehenden Beschreibung entnehmen.

In vorstehenden Ausführungsbeispielen ist von einem Spin-Echo die Rede, aus welchem der Flüssigkeitsanteil bestimmt wird. Diese Ausführungsbeispiele werden z. B. erweitert, indem das Bestimmen des Flüssigkeitsanteils aus mehreren Spin-Echos erfolgt, sodass das Bestimmen zuverlässiger und/oder genauer ist. Die weiteren Spin-Echos werden dabei durch weitere Refokussierungspulse im Anregungssignal erzeugt.

### Bezugszeichen

- 1: kernmagnetisches Durchflussmessgerät
- 2: Messrohr
- 3: Messvolumen
- 4: Messvorrichtung
- 5: Magnetisierungsvorrichtung
- 6: Medium
- 7: flüssiger Anteil des Mediums
- 8: gasförmiger Anteil des Mediums
- 9: Magnetfeld
- 10: Magnetfeldrichtung
- 11: Gradientenmagnetfeld
- 12: erste Gradientenrichtung
- 13: CPMG-Pulsfolge
- 14: Anregungspuls
- 15: Refokussierungspuls
- 16: Spin-Echo
- 17: erster Abschnitt
- 18: zweiter Abschnitt
- 19: erster Anregungspuls
- 20: erster Refokussierungspuls
- 21: zweiter Refokussierungspuls
- 22: zweiter Anregungspuls
- 23: MMME-Pulsfolge
- 24: CHIRP-Pulsfolge
- 25: FID

## Patentansprüche

1. Verfahren zum Bestimmen eines Flüssigkeitsanteils eines strömenden Mediums (6) mit einem kernmagnetischen Durchflussmessgerät (1),
wobei das kernmagnetische Durchflussmessgerät (1) ein Messrohr (2) mit einem Messvolumen (3), eine Messvorrichtung (4) und eine Magnetisierungsvorrichtung (5) aufweist,
wobei das Medium (6) durch das Messrohr (2) geströmt wird und einen flüssigen Anteil (7) und einen gasförmigen Anteil (8) aufweist,
wobei ein Magnetfeld (9) entlang einer Magnetfeldrichtung (10) im Messvolumen (3) von der Magnetisierungsvorrichtung (5) erzeugt und das Medium (6) durch das Magnetfeld (9) magnetisiert wird,
wobei in einem Gradientenschritt von der Magnetisierungsvorrichtung (5) ein Gradientenmagnetfeld (11) mit einem Stärkegradienten entlang einer ersten Gradientenrichtung (12) im Messvolumen (3) erzeugt und das Medium (6) dem Gradientenmagnetfeld (11) zusätzlich zum Magnetfeld (9) ausgesetzt wird,
wobei die folgenden Messschritte von der Messvorrichtung (4) ausgeführt werden:
- Erzeugen und Einstrahlen eines mindestens einen Anregungspuls (14, 19, 22) aufweisenden Anregungssignals in das magnetisierte Medium (6) im Messvolumen (3) zum Anregen von kernmagnetischen Resonanzen im magnetisierten Medium (6) entlang der ersten Gradientenrichtung (12),
- Messen von vom Anregungssignal angeregten kernmagnetischen Resonanzen im magnetisierten Medium (6) entlang der ersten Gradientenrichtung (12) im Messvolumen (3) als ein Messsignal,
- Bestimmen von Frequenzen der kernmagnetischen Resonanzen im Messsignal entlang der ersten Gradientenrichtung (12),
wobei dann die folgenden Auswertungsschritte von der Messvorrichtung (4) ausgeführt werden:
- Zuordnen der bestimmten Frequenzen zu Positionen entlang der ersten Gradientenrichtung (12),
- Zuordnen der kernmagnetischen Resonanzen an den Positionen zum flüssigen Anteil (7) und zum gasförmigen Anteil (8) des Mediums (6);
**dadurch gekennzeichnet, dass** der folgende Auswertungsschritt von der Messvorrichtung ausgeführt wird:
- Bestimmen eines Flüssigkeitsanteils des strömenden Mediums (6) im Messvolumen (3) aus den Positionen der kernmagnetischen Resonanzen des flüssigen Anteils (7) und den Positionen der kernmagnetischen Resonanzen des gasförmigen Anteils (8) des Mediums (6),
und dass von der Magnetisierungsvorrichtung (4) eine Bandbreite für den mindestens einen Anregungspuls (14, 19, 22) basierend auf einer Homogenität des Magnetfelds (9) und einer Stärke des Stärkegradienten des Gradientenmagnetfeldes (11) bestimmt wird.

2. Verfahren nach Anspruch 1, **dadurch gekennzeichnet, dass** das Messrohr (2) horizontal und die erste Gradientenrichtung (12) vertikal orientiert werden.

3. Verfahren nach Anspruch 1 oder 2, **dadurch gekennzeichnet**, eine Homogenität des Magnetfelds (9) bestimmt wird, dass eine Stärke für den Stärkegradienten basierend auf der bestimmten Homogenität und einer geforderten Präzision entlang der Gradientenrichtung (12) bestimmt wird und dass bevorzugt die geforderte Präzision innerhalb von 10 %, bevorzugter innerhalb von 5 % und besonders bevorzugt innerhalb von 1 % einer Strecke entlang der Gradientenrichtung (12) im Messvolumen (3) liegt.

4. Verfahren nach einem der Ansprüche 1 bis 3, **dadurch gekennzeichnet, dass** der mindestens eine Anregungspuls (14, 19, 22) zum Rotieren von magnetischen Momenten des magnetisieren Mediums (6) um Winkel zwischen 5° und 45° und bevorzugt um Winkel von 90° erzeugt wird und dass bevorzugt ein Hard-, ein Soft-, ein adiabatischer, ein CHIRP- (24) oder ein WURST-Puls als der mindestens eine Anregungspuls (14, 19, 22) verwendet wird.

5. Verfahren nach Anspruch 4, **dadurch gekennzeichnet, dass** von der Magnetisierungsvorrichtung (4) eine Stärke der kernmagnetischen Resonanzen in Bezug auf ihre Frequenzen bestimmt wird und dass die Stärke der kernmagnetischen Resonanzen in Bezug auf ihre Frequenzen normalisiert wird, sodass eine frequenzabhängige Effizienz der Anregung der kernmagnetischen Resonanzen durch den mindestens einen Anregungspuls (14, 19, 22) kompensiert ist.

6. Verfahren nach einem der Ansprüche 1 bis 5, **dadurch gekennzeichnet, dass** das Anregungssignal mindestens einen Refokussierungspuls (15, 20, 21) aufweist und dass bevorzugt der mindestens eine Refokussierungspuls (15, 20, 21) zum Rotieren von magnetischen Momenten des magnetisieren Mediums um Winkel von 45° und bevorzugter um Winkel von 180° erzeugt wird und dass bevorzugt ein Hard-, ein Soft-, ein adiabatischer, ein CHIRP-(24) oder ein WURST-Puls als der mindestens eine Refokussierungspuls (15, 20, 21) verwendet wird.

7. Verfahren nach einem der Ansprüche 1 bis 6, **dadurch gekennzeichnet, dass** das Anregungssignal eine Multi-Echo-Pulsfolge (13, 23) aufweist, dass von der Multi-Echo-Pulsfolge (13, 23) im magnetisierten Medium (6) angeregte kernmagnetische Resonanzen gemessen und ausgewertet werden, insbesondere durch Bestimmen von mindestens einer Durchflussgeschwindigkeit des magnetisierten Mediums (6) ausgewertet werden, und dass bevorzugt eine CPMG-, eine SSFP oder eine MMME-Pulsfolge als die Multi-Echo-Pulsfolge (13, 23) verwendet wird.

8. Verfahren nach einem der Ansprüche 1 bis 7, **dadurch gekennzeichnet, dass** das Anregungssignal den Anregungspuls (14, 19, 22) gefolgt von einem Refokussierungspuls (15, 20 21) aufweist, dass ein vom Refokussierungspuls (15, 20 21) angeregtes Spin-Echo (16) gemessen wird und dass bevorzugt der Refokussierungspuls (15, 20 21) zum Rotieren von magnetischen Momenten im magnetisierten Medium (6) um Winkel von 180° erzeugt wird.

9. Verfahren nach Anspruch 8, **dadurch gekennzeichnet, dass** das Anregungssignal eine CPMG-Pulsfolge (13) aufweist, dass der Anregungspuls (14) und der Refokussierungspuls (15) ein Teil der CPMG-Pulsfolge (13) sind, dass von der CPMG-Pulsfolge (13) angeregte kernmagnetische Resonanzen gemessen und ausgewertet werden, insbesondere durch Bestimmen von mindestens einer Durchflussgeschwindigkeit des magnetisierten Mediums (6) ausgewertet werden.

10. Verfahren nach einem der Ansprüche 1 bis 9, **dadurch gekennzeichnet, dass** das Anregungssignal einen ersten Anregungspuls (19) gefolgt von einem ersten Refokussierungspuls (20) und einem zweiten Refokussierungspuls (21) gefolgt von einem zweiten Anregungspuls (22) zum Kompensieren von noch vorhandenen kernmagnetischen Resonanzen aufweist, dass ein Spin-Echo (16) zwischen dem ersten Refokussierungspuls (20) und dem zweiten Refokussierungspuls (21) als ein Teil des Messsignals gemessen wird und dass bevorzugt der zweite Anregungspuls (22) eine Phasenverschiebung von 180° gegenüber dem ersten Anregungspuls (19) aufweist.

11. Verfahren nach Anspruch 10, **dadurch gekennzeichnet, dass** das Anregungssignal eine CPMG-Pulsfolge (13) aufweist, dass die CPMG-Pulsfolge (13) auf den zweiten Anregungspuls (22) folgt, dass zwischen dem zweiten Anregungspuls (22) und der CPMG-Pulsfolge (13) das Gradientenmagnetfeld (11) reduziert wird, bevorzugt auf Null, dass von der CPMG-Pulsfolge (13) angeregte kernmagnetische Resonanzen gemessen und ausgewertet werden, insbesondere durch Bestimmen von mindestens einer Durchflussgeschwindigkeit des magnetisierten Mediums (6) ausgewertet werden.

12. Verfahren nach Anspruch 10, **dadurch gekennzeichnet, dass** das Anregungssignal eine MMME-Pulsfolge (23) aufweist, dass die MMME-Pulsfolge (23) auf den zweiten Anregungspuls (22) folgt, dass zwischen dem zweiten Anregungspuls (22) und der MMME-Pulsfolge (23) das Gradientenmagnetfeld (11) zunächst auf Null reduziert wird und dann wieder erhöht wird in einer zweiten Gradientenrichtung, dass bevorzugt die zweite Gradientenrichtung senkrecht zur ersten Gradientenrichtung (12) ist, dass von der MMME-Pulsfolge (23) angeregte kernmagnetische Resonanzen gemessen und ausgewertet werden, insbesondere durch Bestimmen von mindestens einer Durchflussgeschwindigkeit des magnetisierten Mediums (6) ausgewertet werden.

13. Verfahren nach einem der Ansprüche 1 bis 12, **dadurch gekennzeichnet, dass** der Gradientenschritt erneut mit einer von der ersten Gradientenrichtung (12) verschiedenen dritten Gradientenrichtung ausgeführt wird, dass dann die Messschritte und die Auswertungsschritte erneut ausgeführt werden, dass eine Präzision der Bestimmung des Flüssigkeitsanteils durch Kombination von beiden Bestimmungen des Flüssigkeitsanteils verbessert wird und dass bevorzugt die dritte Gradientenrichtung senkrecht zur ersten Gradientenrichtung (12) ist.

## Claims

1. Method for determining a liquid portion of a flowing medium (6) with a nuclear magnetic flowmeter (1),
wherein the nuclear magnetic flowmeter (1) comprises a measuring tube (2) with a measuring volume (3), a measuring device (4) and a magnetizing device (5),
wherein the medium (6) is made to flow through the measuring tube (2) and has a liquid portion (7) and a gaseous portion (8),
wherein a magnetic field (9) is generated along a magnetic field direction (10) in the measuring volume (3) by the magnetizing device (5) and the medium (6) is magnetized by the magnetic field (9),
wherein, in a gradient step, a gradient magnetic field (11) with a strength gradient along a first gradient direction (12) is generated in the measuring volume (3) by the magnetizing device (5) and the medium (6) is exposed to the gradient magnetic field (11) in addition to the magnetic field (9),
wherein the following measurement steps are carried out by the measuring device (4):
- generating and irradiating an excitation signal into the magnetized medium (6) having at least one excitation pulse (14, 19, 22) in the measuring volume (3) for exciting nuclear magnetic resonances in the magnetized medium (6) along the first gradient direction (12),
- measuring nuclear magnetic resonances excited by the excitation signal in the magnetized medium (6) along the first gradient direction (12) in the measuring volume (3) as a measuring signal,
- determining frequencies of the nuclear magnetic resonances in the measuring signal along the first gradient direction (12),
wherein the following evaluation steps are then carried out by the measuring device (4):
- assigning the determined frequencies to positions along the first gradient direction (12),
- assigning the nuclear magnetic resonances at the positions to the liquid portion (7) and to the gaseous portion (8) of the medium (6),
**characterized in**
**that** the following evaluation step is carried out by the measuring device:
- determining a liquid portion of the flowing medium (6) in the measuring volume (3) from the positions of the nuclear magnetic resonances of the liquid portion (7) and the positions of the nuclear magnetic resonances of the gaseous portion (8) of the medium (6), and
**that** a bandwidth for the at least one excitation pulse (14, 19, 22) based on a homogeneity of the magnetic field (9) and a strength of the strength gradient of the gradient magnetic field (11) is determined by the magnetizing device.

2. Method according to claim 1, **characterized in that** the measuring tube (2) is oriented horizontally and the first gradient direction (12) is oriented vertically.

3. Method according to claim 1 or 2, **characterized in that** a homogeneity of the magnetic field (9) is determined, that a strength for the strength gradient is determined based on the determined homogeneity and a required precision along the gradient direction (12) and that, preferably, the required precision is within 10%, more preferably within 5% and particularly preferably within 1% of a distance along the gradient direction (12) in the measuring volume (3).

4. Method according to any one of claims 1 to 3, **characterized in that** the at least one excitation pulse (14, 19, 22) is generated for rotating magnetic moments of the magnetized medium (6) by angles between 5° and 45° and more preferably by angles of 90° and that, preferably, a hard, a soft, an adiabatic, a CHIRP (24) or a WURST pulse is used as the at least one excitation pulse (14, 19, 22).

5. Method according to claim 4, **characterized in that** a strength of the nuclear magnetic resonances with respect to their frequencies is determined by the magnetization device (4) and that the strength of the nuclear magnetic resonances with respect to their frequencies is normalized so that a frequency-dependent efficiency of the excitation of the nuclear magnetic resonances by the at least one excitation pulse (14, 19, 22) is compensated.

6. Method according to any one of claims 1 to 5, **characterized in that** the excitation signal comprises at least one refocusing pulse (15, 20, 21) and that, preferably, the at least one refocusing pulse (15, 20, 21) is generated for rotating magnetic moments of the magnetized medium by angles of 45° and, more preferably by angles of 180° and that, preferably, a hard, a soft, an adiabatic, a CHIRP (24) or a WURST pulse is used as the at least one refocusing pulse (15, 20, 21).

7. Method according to any one of claims 1 to 6, **characterized in that** the excitation signal comprises a multi-echo pulse sequence (13, 23), that nuclear magnetic resonances excited by the multi-echo pulse sequence (13, 23) in the magnetized medium (6) are measured and evaluated, in particular by determining at least one flow rate of the magnetized medium (6), and that preferably a CPMG, an SSFP or an MMME pulse sequence is used as the multi-echo pulse sequence (13, 23).

8. Method according to any of claims 1 to 7, **characterized in that** the excitation signal comprises the excitation pulse (14, 19, 22) followed by a refocusing pulse (15, 20 21), that a spin echo (16) excited by the refocusing pulse (15, 20 21) is measured, and that, preferably, the refocusing pulse (15, 20 21) is generated for rotating magnetic moments in the magnetized medium (6) by angles of 180°.

9. Method according to claim 8, **characterized in that** the excitation signal comprises a CPMG pulse sequence (13), that the excitation pulse (14) and the refocusing pulse (15) are part of the CPMG pulse sequence (13), that nuclear magnetic resonances excited by the CPMG pulse sequence (13) are measured and evaluated, in particular by determining at least one flow rate of the magnetized medium (6).

10. Method according to any one of claims 1 to 9, **characterized in that** the excitation signal comprises a first excitation pulse (19) followed by a first refocusing pulse (20) and a second refocusing pulse (21) followed by a second excitation pulse (22) for compensating for nuclear magnetic resonances still present, that a spin echo (16) is measured between the first refocusing pulse (20) and the second refocusing pulse (21) as a part of the measuring signal, and that, preferably, the second excitation pulse (22) has a phase shift of 180° with respect to the first excitation pulse (19).

11. Method according to claim 10, **characterized in that** the excitation signal has a CPMG pulse sequence (13), that the CPMG pulse sequence (13) follows the second excitation pulse (22), that, between the second excitation pulse (22) and the CPMG pulse sequence (13), the gradient magnetic field (11) is reduced, preferably to zero, that nuclear magnetic resonances excited by the CPMG pulse sequence (13) are measured and evaluated, in particular by determining at least one flow rate of the magnetized medium (6).

12. Method according to claim 10, **characterized in that** the excitation signal comprises an MMME pulse sequence (23), that the MMME pulse sequence (23) follows the second excitation pulse (22), that, between the second excitation pulse (22) and the MMME pulse sequence (23), the gradient magnetic field (11) is first reduced to zero and then increased again in a second gradient direction, that, preferably, the second gradient direction is perpendicular to the first gradient direction (12), that nuclear magnetic resonances excited by the MMME pulse sequence (23) are measured and evaluated, in particular by determining at least one flow rate of the magnetized medium (6).

13. Method according to any one of claims 1 to 12, **characterized in that** the gradient step is carried out again with a third gradient direction different from the first gradient direction (12), that, then, the measurement steps and the evaluation steps are carried out again, that a precision of the determination of the liquid portion is improved by combining both determinations of the liquid portion and that, preferably, the third gradient direction is perpendicular to the first gradient direction (12).

## Revendications

1. Procédé de détermination d'une proportion de liquide d'un milieu en écoulement (6) au moyen d'un débitmètre magnétique nucléaire (1),
le débitmètre magnétique nucléaire (1) présentant un tube de mesure (2) avec un volume de mesure (3), un dispositif de mesure (4) et un dispositif de magnétisation (5),
le milieu (6) s'écoulant à travers le tube de mesure (2) et présentant une partie liquide (7) et une partie gazeuse (8),
un champ magnétique (9) étant généré le long d'une direction de champ magnétique (10) dans le volume de mesure (3) par le dispositif de magnétisation (5) et le milieu (6) étant magnétisé par le champ magnétique (9), le dispositif de magnétisation (5), dans une étape de gradient, générant un champ magnétique à gradient (11) avec un gradient d'intensité le long d'une première direction de gradient (12) dans le volume de mesure (3), et le milieu (6) étant exposé au champ magnétique à gradient (11) en plus du champ magnétique (9),
les étapes de mesure suivantes étant mises en œuvre par le dispositif de mesure (4) :
- générer et irradier un signal d'excitation comprenant au moins une impulsion d'excitation (14, 19, 22) dans le milieu (6) magnétisé, dans le volume de mesure (3), afin d'exciter des résonances magnétiques nucléaires dans le milieu (6) magnétisé, le long de la première direction de gradient (12),
- mesurer les résonances magnétiques nucléaires excitées par le signal d'excitation dans le milieu (6) magnétisé, le long de la première direction de gradient (12), dans le volume de mesure (3) en tant que signal de mesure,
- déterminer les fréquences des résonances magnétiques nucléaires dans le signal de mesure le long de la première direction de gradient (12),
les étapes d'évaluation suivantes étant alors mises en œuvre par le dispositif de mesure (4) :
- attribuer les fréquences déterminées à des positions le long de la première direction de gradient (12),
- attribuer à la partie liquide (7) et à la partie gazeuse (8) du milieu (6) les résonances magnétiques nucléaires, aux positions ;
**caractérisé en ce que** l'étape d'évaluation suivante est mise en œuvre par le dispositif de mesure :
- déterminer une proportion de liquide du milieu en écoulement (6) dans le volume de mesure (3) à partir des positions des résonances magnétiques nucléaires de la partie liquide (7) et des positions des résonances magnétiques nucléaires de la partie gazeuse (8) du milieu (6),
et **en ce que** le dispositif de magnétisation (4) détermine une largeur de bande pour ladite au moins une impulsion d'excitation (14, 19, 22) sur la base d'une homogénéité du champ magnétique (9) et d'une intensité du gradient d'intensité du champ magnétique à gradient (11).

2. Procédé selon la revendication 1, **caractérisé en ce que** le tube de mesure (2) est orienté horizontalement et la première direction de gradient (12) est orientée verticalement.

3. Procédé selon la revendication 1 ou la revendication 2, **caractérisé en ce qu'**une homogénéité du champ magnétique (9) est déterminée, **en ce qu'**une intensité pour le gradient d'intensité est déterminée sur la base de l'homogénéité déterminée et d'une précision requise le long de la direction du gradient (12) et **en ce que**, de préférence, la précision requise se situe dans les 10 %, de préférence dans les 5 %, et de manière particulièrement préférée dans les 1 %, d'une distance le long de la direction du gradient (12) dans le volume de mesure (3).

4. Procédé selon l'une des revendications 1 à 3, **caractérisé en ce que** ladite au moins une impulsion d'excitation (14, 19, 22) est générée de façon à faire tourner les moments magnétiques du milieu (6) magnétisé selon des angles compris entre 5° et 45° et de préférence selon des angles de 90°, et **en ce que** l'on utilise de préférence une impulsion dure, une impulsion douce, une impulsion adiabatique, une impulsion CHIRP (24) ou une impulsion WURST en tant que ladite au moins une impulsion d'excitation (14, 19, 22).

5. Procédé selon la revendication 4, **caractérisé en ce qu'**une intensité des résonances magnétiques nucléaires par rapport à leurs fréquences est déterminée par le dispositif de magnétisation (4) et **en ce que** l'intensité des résonances magnétiques nucléaires par rapport à leurs fréquences est normalisée de sorte qu'une efficacité dépendant de la fréquence de l'excitation des résonances magnétiques nucléaires est compensée par ladite au moins une impulsion d'excitation (14, 19, 22).

6. Procédé selon l'une des revendications 1 à 5, **caractérisé en ce que** le signal d'excitation comprend au moins une impulsion de refocalisation (15, 20, 21) et **en ce que**, de préférence, ladite au moins une impulsion de refocalisation (15, 20, 21) est générée de façon à faire tourner les moments magnétiques du milieu magnétisé sur des angles de 45° et, de préférence, sur des angles de 180°, et **en ce que**, de préférence, une impulsion dure, une impulsion douce, une impulsion adiabatique, une impulsion CHIRP (24) ou une impulsion WURST est utilisée en tant que ladite au moins une impulsion de refocalisation (15, 20, 21).

7. Procédé selon l'une des revendications 1 à 6, **caractérisé en ce que** le signal d'excitation présente un train d'impulsions multi-écho (13, 23), **en ce que** des résonances magnétiques nucléaires excitées par le train d'impulsions multi-écho (13, 23) dans le milieu (6) magnétisé sont mesurées et évaluées, en particulier évaluées par la détermination d'au moins une vitesse d'écoulement du milieu (6) magnétisé, et **en ce que**, de préférence, un train d'impulsions CPMG, un train d'impulsions SSFP ou un train d'impulsions MMME est utilisé en tant que train d'impulsions multi-écho (13, 23) .

8. Procédé selon l'une des revendications 1 à 7, **caractérisé en ce que** le signal d'excitation comprend l'impulsion d'excitation (14, 19, 22) suivie d'une impulsion de refocalisation (15, 20, 21), **en ce qu'**un écho de spin (16) excité par l'impulsion de refocalisation (15, 20, 21) est mesuré et **en ce que**, de préférence, l'impulsion de refocalisation (15, 20, 21) est générée de façon à faire tourner des moments magnétiques dans le milieu (6) magnétisé sur des angles de 180°.

9. Procédé selon la revendication 8, **caractérisé en ce que** le signal d'excitation présente un train d'impulsions CPMG (13), **en ce que** l'impulsion d'excitation (14) et l'impulsion de refocalisation (15) font partie du train d'impulsions CPMG (13), **en ce que** des résonances magnétiques nucléaires excitées par le train d'impulsions CPMG (13) sont mesurées et évaluées, en particulier sont évaluées par détermination d'au moins une vitesse de passage du milieu (6) magnétisé.

10. Procédé selon l'une des revendications 1 à 9, **caractérisé en ce que** le signal d'excitation comprend une première impulsion d'excitation (19) suivie d'une première impulsion de refocalisation (20), et une deuxième impulsion de refocalisation (21) suivie d'une deuxième impulsion d'excitation (22) pour compenser les résonances magnétiques nucléaires encore présentes, **en ce qu'**un écho de spin (16) est mesuré entre la première impulsion de refocalisation (20) et la deuxième impulsion de refocalisation (21) en tant que partie du signal de mesure et **en ce que**, de préférence, la deuxième impulsion d'excitation (22) présente un déphasage de 180° par rapport à la première impulsion d'excitation (19).

11. Procédé selon la revendication 10, **caractérisé en ce que** le signal d'excitation présente un train d'impulsions CPMG (13), **en ce que** le train d'impulsions CPMG (13) suit la deuxième impulsion d'excitation (22), **en ce qu'**entre la deuxième impulsion d'excitation (22) et le train d'impulsions CPMG (13), le champ magnétique à gradient (11) est réduit, de préférence à zéro, **en ce que** des résonances magnétiques nucléaires excitées par le train d'impulsions CPMG (13) sont mesurées et évaluées, notamment par détermination d'au moins une vitesse d'écoulement du milieu (6) magnétisé.

12. Procédé selon la revendication 10, **caractérisé en ce que** le signal d'excitation présente un train d'impulsions MMME (23), **en ce que** le train d'impulsions MMME (23) suit la deuxième impulsion d'excitation (22), **en ce qu'**entre la deuxième impulsion d'excitation (22) et le train d'impulsions MMME (23), le champ magnétique à gradient (11) est d'abord réduit à zéro puis est à nouveau augmenté dans une deuxième direction de gradient, **en ce que**, de préférence, la deuxième direction de gradient est perpendiculaire à la première direction de gradient (12), **en ce que** des résonances magnétiques nucléaires excitées par le train d'impulsions MMME (23) sont mesurées et évaluées, notamment en déterminant au moins une vitesse d'écoulement du milieu (6) magnétisé.

13. Procédé selon l'une des revendications 1 à 12, **caractérisé en ce que** l'étape de gradient est à nouveau réalisée avec une troisième direction de gradient différente de la première direction de gradient (12), **en ce que** les étapes de mesure et les étapes d'évaluation sont alors à nouveau réalisées, **en ce qu'**une précision de la détermination de la proportion de liquide est améliorée par combinaison des deux déterminations de la proportion de liquide et **en ce que**, de préférence, la troisième direction de gradient est perpendiculaire à la première direction de gradient (12).
